Europäisches Patentamt

European Patent Office

Office européen des brevets

(11) Veröffentlichungsnummer: **0 227 971**
A1

## (12) EUROPÄISCHE PATENTANMELDUNG

(21) Anmeldenummer: 86116740.1

(22) Anmeldetag: 02.12.86

(51) Int. Cl.⁴: **H01L 29/78** , H01L 21/28 , H01L 27/08

(30) Priorität: 17.12.85 DE 3544591

(43) Veröffentlichungstag der Anmeldung:
08.07.87 Patentblatt 87/28

(84) Benannte Vertragsstaaten:
AT DE FR GB IT NL

(71) Anmelder: Siemens Aktiengesellschaft Berlin und München
Wittelsbacherplatz 2
D-8000 München 2(DE)

(72) Erfinder: Klose, Helmut, Dipl.-Ing.
Steinickeweg 7
D-8000 München 80(DE)
Erfinder: Schaber, Hans-Christian, Dr.
Ruffiniallee 26
D-8032 Gräfelfing(DE)

(54) **MOS-Transistor mit kurzer Gatelänge für hochintegrierte Schaltungen und Verfahren zu seiner Herstellung.**

(57) Bei einem MOS-Transistor für hochintegrierte Schaltungen, bei dem durch Ausdiffusion aus einer strukturierten leitfähigen Schicht (3) in das Halbleitersubstrat (1) die Source/Drain-Zonen (11) erzeugt werden, ist an den Source/Drain-Strukturflanken (3) zusätzlich eine Isolationsschicht (7) angeordnet. Die Gate-Elektrode (10) befindet sich in der gleichen Ebene wie die Source/Drain-Strukturen (3), die als spätere Kontaktanschlüsse dienen und erstreckt sich direkt zwischen den mit der Isolationsschicht (7) versehenen Flanken der Source/Drain-Strukturen (3). Die Gatelänge ist bestimmt durch den minimalen Strukturabstand der verwendeten Lithographie abzüglich 2 mal der Breite der Flankenisolation (7). Es lassen sich Gatelängen weit unter 0,5 μm herstellen; außerdem wird die selbstjustierte Kontaktierung der Source/Drain-Zonen (11) ermöglicht. Der Transistor und das Verfahren zu seiner Herstellung wird verwendet für Baulemente mit großen Schaltgeschwindigkeiten und hoher Packungsdichte.

FIG 8

# MOS-Transistor mit kurzer Gatelänge für hochintegrierte Schaltungen und Verfahren zur seiner Herstellung.

Die Erfindung betrifft einen MOS-Transistor für hochintegrierte Schaltungen mit durch Ausdiffusion aus einer strukturierten, leitfähigen Schicht in ein Halbleitersubstrat erzeugten Source/Drain-Zonen und mit einer, durch eine Isolationsschicht vom Substrat getrennten, über der zwischen den Source/Drain-Zonen liegenden Kanalzone angeordneten Gate-Elektrode, sowie Verfahren zu seiner Herstellung.

Ein solcher MOS-Transistor sowie ein Verfahren zu seiner Herstellung ist beispielsweise aus dem IBM Technical Disclosure Bulletin Vol. 23, Nr. 4, April 1981, auf den Seiten 5190 bis 5193, zu entnehmen. Bei dieser Transistorstruktur sind die Source/Drain-Kontakte, die von der Gate-Elektrode durch ein Flankenoxid getrennt sind, selbstjustierend zur Gate-Elektrode ausgebildet. Dadurch kann die Packungsdichte der Bauelemente in einer integrierten Schaltung wesentlich erhöht werden.

Für Bauelemente in hoher Packungsdichte und mit großen Schaltgeschwindigkeiten spielen neben parasitären Leitungskapazitäten die parasitären Kapazitäten in den Transistoren selbst eine große Rolle, da sie eine Begrenzung für die erreichbaren Gatterlaufzeiten darstellen. Die laterale Ausdiffusion der hochdotierten Source/Drain-Zonen in Gebiete unterhalb der Transistorgates führt zu einer wesentlichen Erhöhung der sogenannten Miller-Kapazität zwischen Gate und Diffusionsgebieten.

Zur Vermeidung hoher Miller-Kapazitäten ist bei Verfahren zur Herstellung von MOS-Transistoren bekannt, die durch die Lithographie bestimmte Gatelänge durch Oxidstege (spacer) zu erhöhen. Diese Oxidstege dienen als Maskierung bei der Implantation der Source/Drain-Zonen. Ein solches Verfahren ist beispielsweise aus einem Aufsatz von Tsang et. al. aus dem IEEE Trans. Electr. Dev., ED-29 (1982), auf den Seiten 590 bis 596, zu entnehmen. Die effektive Kanallänge ist dabei im Idealfall gleich der Minimalstruktur der verwendeten Lithographie; für kleinere effektive Gatelängen wächst entweder die Miller-Kapazität durch die Unterdiffusion der Source/Drain-Zonen unter die Gate-Elektrode stark an oder die Reproduzierbarkeit des Prozesses ist zum Beispiel durch die Unterätzung der Photolackmaske bei der Strukturierung der Gate-Elektrode ungenügend.

Die Aufgabe, die der Erfindung zugrundeliegt, besteht in der Herstellung eines MOS-Transistors für Hochgeschwindigkeitsanwendungen mit kurzem Gate, dessen Gatelänge nicht durch die minimal auflösbare Strukturbreite der verwendeten Lithographie begrenzt ist und bei dem die durch die Verkürzung der Gatelänge bedingte erhöhte Miller-Kapazität nicht in Kauf genommen werden muß.

Diese Aufgabe wird bei einem MOS-Transistor der eingangs genannten Art dadurch gelöst, daß die für die Erzeugung der Source/Drain-Zonen direkt auf dem Substrat aufgebrachte, leitfähige Schichtstruktur, die die späteren Kontaktanschlüsse für die Source/Drain-Zonen bildet, zumindest an ihren, der Gate-Elektrode zugewandten Flanken eine Isolationsschicht aufweist und sich die Gate-Elektrode in der gleichen Ebene und direkt zwischen den mit der Isolationsschicht versehenen Flanken der Source/Drain-Strukturen erstreckt.

Es liegt im Rahmen der Erfindung, daß die Isolationsschicht aus $SiO_2$ und die leitfähige Schichtstruktur für die Source/Drain-Anschlüsse und die Gate-Elektrode aus mit einer Dotierung versehenen Schicht aus Polysilizium, Metallsilizid oder einer Doppelschicht von Polysilizium und Metallsilizid besteht.

Die erfindungsgemäße Transistorstruktur mit der kurzen Gatelänge wird ermöglicht durch ein Verfahren, bei dem die zur Ausdiffusion der Source/Drain-Zonen auf dem Halbleitersubstrat direkt aufgebrachten und als spätere Kontaktanschlüsse dienenden Schichtstrukturen vor der Herstellung der Gate-Elektrode an ihren mindestens in Richtung der Gate-Elektrode liegenden Flanken mit einer zusätzlich aufgebrachten Isolationsschicht belegt werden, wobei die Dicke der Isolationsschicht entsprechend der gewünschten Länge des dazwischenliegenden Gates gewählt wird. Bei dem erfindungsgemäßen Verfahren ist die Gatelänge gegeben durch den minimalen Strukturabstand der verwendeten Lithographie abzüglich 2 mal der Breite des lateralen Isolationssteges an den Flanken der Source/Drain-Strukturen; das heißt, bei 1 μm-Strukturabstand der Lithographie können Gatelängen weit unter 0,5 μm reproduzierbar hergestellt werden.

Für die kritischen Strukturierungsprozesse werden ausschließlich Trockenätzverfahren eingesetzt.

Weitere Ausgestaltungen der Erfindung ergeben sich aus den Unteransprüchen.

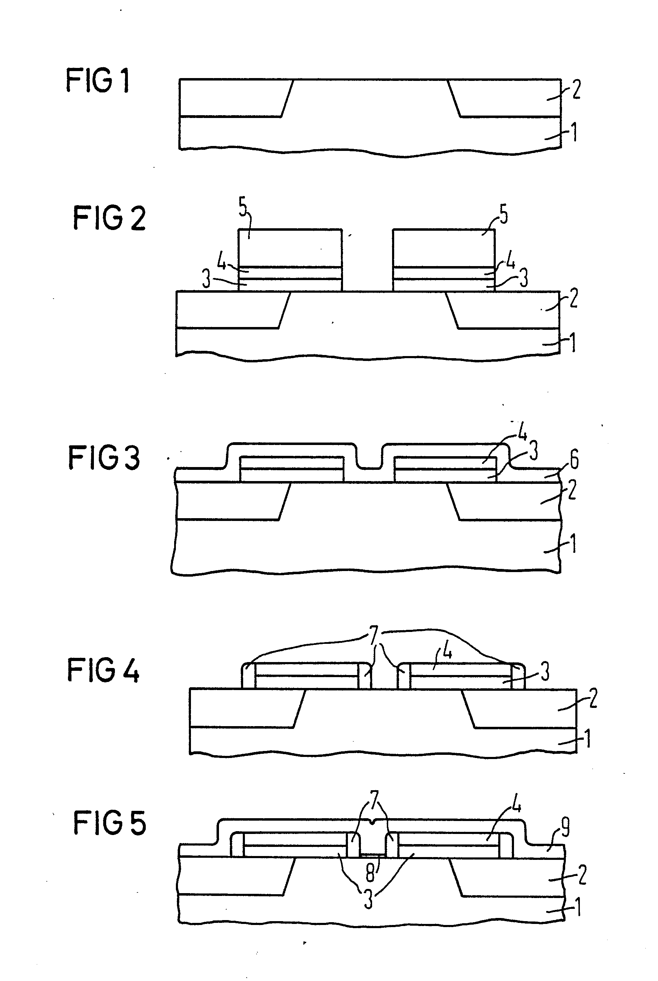

Nähere Einzelheiten werden nachfolgend anhand eines Ausführungsbeispieles und der Figuren 1 bis 8, welche im Schnittbild die erfindungswesentlichen Verfahrensschritte darstellen, noch näher beschrieben. Es wird der Prozeßablauf zur Herstellung eines n-Kanal-MOS-Transistors beschrieben. Das erfindungsgemäße Verfahren ist aber auch für die Herstellung von p-Kanal-Transistoren anwendbar. In allen Figuren gelten für gleiche Teile gleiche Bezugzeichen.

Figur 1 zeigt die Anordnung nach der Durchführung des LOCOS-Prozesses ( = local oxidation of silicon) zur Definition der aktiven Transistorbereiche durch Erzeugung der Feldoxidbereiche 2 auf dem einkristallinen p-dotierten Substrat 1. Zur Einstellung der Schwellspannung und zum Unterbinden des punch-through kann in bekannter Weise eine doppelte Kanalimplantation mit Bor-Ionen durchgeführt werden (in der Figur der Übersichtlichkeit wegen nicht dargestellt).

Figur 2: Eine erste leitfähige Schicht (3), zum Beispiel in Form von Polysilizium, Metallsilizid oder einer Doppelschicht aus Polysilizium und Metallsilizid, wird ganzflächig abgeschieden, für die spätere Ausdiffusion der Source/Drain-Zonen mit einer $n^+$-Dotierung -entweder bei der Abscheidung oder anschließend durch Implantation von Phosphor und Arsen-Ionen -versehen und mittels einer darüber abgeschiedenen ersten Isolatorschicht 4 aus $SiO_2$ oder Siliziumnitrid mittels einer Photolackmaske 5 durch Trockenätzen, vorzugsweise durch reaktives Ionenätzen in einer Gasmischung aus Tetrachlorkohlenstoff und Helium so strukturiert, daß die für die Ausdiffusion und spätere Kontaktierung der Source/Drain-Zonen dienenden Anschlüsse 3 mit dem dazwischenliegenden Gate-Bereich entstehen. Aus der Figur 2 ist zu ersehen, daß das Ätzverfahren vertikale Profile erzeugt.

Figur 3: Nach Entfernung der Photolackmaske 5 wird eine zweite Isolatorschicht 6 aus zum Beispiel $SiO_2$ in einer Schichtdicke im Bereich von 100 bis 200 nm ganzflächig aufgebracht, welche der späteren Flankenisolation (7) der Source/Drain-Strukturen (3) dient. Mit dieser Abscheidung und mit der für die Source/Drain-Strukturen (3) vorgegebenen Photolackmaske 5 (Figur 2) wird die Gatelänge bestimmt.

Figur 4: Der nächste Schritt besteht in der Durchführung eines weiteren Trockenätzprozesses, in welchem das Flankenoxid 7 durch Rückätzen der Schicht 6 gebildet wird. Dieser Ätzprozeß erfolgt mittels einer Gasmischung aus Trifluormethan und 5 bis 8 % Sauerstoff.

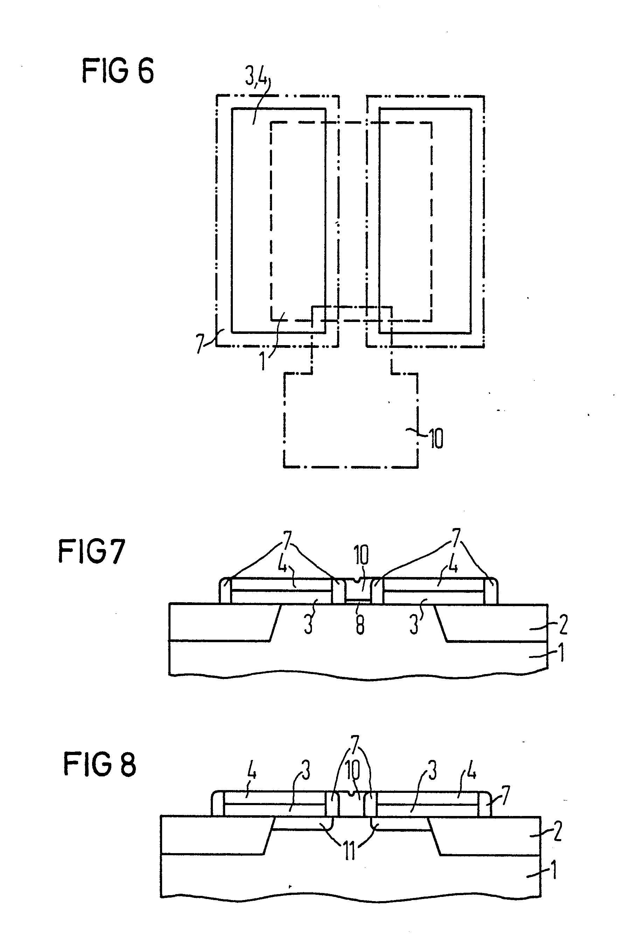

Figur 5 zeigt das thermische Aufwachsen des Gateoxids 8 in einer Schichtdicke von 25 nm und die anschließende ganzflächige Abscheidung der zweiten leitfähigen Schicht 9, welche die spätere Gate-Elektrode 10 bildet und aus Polysilizium, Metallsilizid, Metall oder aus einer Doppelschicht von Polysilizium und Metallsilizid bestehen kann. Die Dotierstoffbelegung ($n^+$) erfolgt zum Beispiel durch eine Phosphor-und/oder Arsen-Ionenimplantation (in der Figur nicht dargestellt). Die Schichtdicke dieser Schicht 9 wird auf mindestens die Hälfte der Gatelänge eingestellt.

Figur 6 zeigt in Draufsicht die Photolacktechnik zur Blockierung des Ätzvorganges an der Stelle des späteren Gateanschlusses bei der Herstellung der Gate-Elektrode (10). Dabei ist mit der strichpunktierten Linie der Bereich der Photolackmaskierung für den Gateanschluß bezeichnet. Die strichlierte Linie zeigt die Grenze des einkristallinen Silizium (1, 3) zu den Feldoxidbereichen (2); die punkt-punkt-strichlierte Linie zeigt die Flankenoxid-(spacer)-Berandung (7) und die durchgezogene Linie die Source/Drain-Strukturen (3).

Figur 7: Das Rückätzen der zweiten, leitfähigen Schicht 9 (in Figur 5) zur Herstellung der Gate-Elektrode 10 zwischen den mit dem Flankenoxid 7 versehenen Source/Drain-Strukturen 3 und des Gateanschlusses erfolgt entweder durch ein anisotropes Ätzverfahren mit einer Photolacktechnik zum Schutz des Gateanschlusses (10) in zwei Schritten, wobei zunächst das $n^+$-Polysilizium (9) auf das Niveau der S/D-Strukturen (3, 4) zurückgeätzt wird und das $n^+$-Polysilizium (9) an den üßeren Kanten der Strukturen (3, 4) entfernt wird, um Kurzschlüsse zu vermeiden, oder durch einen isotropen Ätzprozeß naß chemisch, um nicht erwünschte Flankenoxidrückstände (sogenannte Ätzresiduen) auf den Feldoxiden 2 zu unterbinden.

Figur 8 zeigt die Anordnung nach der Ausdiffusion der Source/Drain-Zonen 11 aus den mit Arsen und/oder Phosphor dotierten Schichtstrukturen 3 bei einer Temperatur von 950 °C.

Die Kontaktierung der Source/Drain-Anschlüsse 3 und des Gateanschlusses (Figur 6) erfolgt in bekannter Weise nach dem Aufbringen einer als Isolationsoxid dienenden Zwischenschicht, Öffnen der Kontaktlochbereiche und Durchführung der Metallisierung.

Durch das erfindungsgemäße Verfahren ergeben sich zusammenfassend folgende Vorteile:

1. Durch die Verwendung der Silizidschichten ist eine niederohmige Kontaktierung der Source/Drain-Gebiete möglich.

2. Die Gate-Elektrode ist bezüglich der Source/Drain-Gebiete selbstjustierend; damit ist eine hohe Packungsdichte der Bauelemente möglich. Außerdem vereinfacht sich der Prozeßablauf durch die Einsparung von aufwendigen Maskenschritten.

3. Kleinere Gatelängen und damit kleinere Kanallängen als bei den bisherigen Verfahren sind bei gleichbleibender Lithographie reproduzierbar zu realisieren.

4. Durch die Flankenisolation an den Source/Drain-Strukturen können minimale Gate-Drain-Kapazitäten (= Miller-Kapazität) eingehalten werden.

Bezugszeichenliste

1 p-dotiertes Siliziumsubstrat
2 Feldoxidbereiche
3 erste leitfähige Schicht
4 erste Isolatorschicht
5 Photolackmaske
6 zweite Isolatorschicht
7 Flankenisolation
8 Gateoxid
9 zweite leitfähige Schicht
10 Gate Elektrode
11 Source/Drain-Zone

**Ansprüche**

1. MOS-Transistor für hochintegrierte Schaltungen mit durch Ausdiffusion aus einer strukturierten, leitfähigen Schicht in ein Halbleitersubstrat erzeugten Source/Drain-Zonen und mit einer, durch eine Isolationsschicht vom Substrat getrennten, über der zwischen den Source/Drain-Zonen liegenden Kanalzone angeordneten Gate-Elektrode, **dadurch gekennzeichnet**, daß die für die Erzeugung der Source/Drain-Zonen (11) direkt auf dem Substrat - (1) aufgebrachte, leitfähige Schichtstruktur (3), die die späteren Kontaktanschlüsse für die Source/Drain-Zonen (11) bildet, zumindest an ihren, der Gate-Elektrode (10) zugewandten Flanken eine Isolationsschicht (7) aufweist und daß sich die Gate-Elektrode (10) in der gleichen Ebene und direkt zwischen den mit der Isolationsschicht (7) versehenen Flanken der Source/Drain-Strukturen - (3) erstreckt.

2. MOS-Transistor nach Anspruch 1, **dadurch gekennzeichnet**, daß die Isolationsschicht (7) aus SiO₂ besteht.

3. MOS-Transistor nach Anspruch 1 oder 2, **dadurch gekennzeichnet**, daß die leitfähigen Schichtstrukturen für die Source/Drain-Anschlüsse - (3) und die Gate-Elektrode (10) aus, mit einer Dotierung versehenen Schicht aus Polysilizium, Metallsilizid oder einer Doppelschicht von Polysilizium und Metallsilizid besteht.

4. Verfahren zum Herstellen von hochintegrierten MOS-Transistoren mit kurzen Gatelängen nach mindestens einem der Ansprüche 1 bis 3, **dadurch gekennzeichnet**, daß die zur Ausdiffusion der Source/Drain-Zonen (11) auf dem Halbleitersubstrat (1) direkt aufgebrachten und als spätere Kontaktanschlüsse dienenden Schichtstrukturen (3) vor der Herstellung der Gate-Elektrode (10) an ihren mindestens in Richtung der Gate-Elektrode (10) liegenden Flanken mit einer zusätzlich aufgebrachten Isolationsschicht (7) belegt werden, wobei die Dicke der Isolationsschicht (7) entsprechend der gewünschten Länge des dazwischenliegenden Gates (10) gewählt wird.

5. Verfahren nach Anspruch 4, **dadurch gekennzeichnet**, daß die Flankenisolation (7) durch eine SiO₂-Schicht gebildet wird und daß bei der Herstellung der Source/Drain-Strukturen (3) und des Flankenoxids Trockenätzprozesse verwendet werden.

6. Verfahren zum Herstellen von n-bzw. p-Kanal-MOS-Transistoren nach Anspruch 4 und 5, **gekennzeichnet durch** den Ablauf der folgenden Verfahrensschritte:

a) Herstellen von strukturieren SiO₂-Schichten (2) auf einem Siliziumhalbleitersubstrat (1) eines ersten Leitungstyps zur Trennung der aktiven Transistorbereiche nach dem sogenannten LOCOS-Verfahren,

b) ganzflächige Abscheidung einer ersten leitfähigen Schicht (3) vom zweiten Leitungstyp,

c) ganzflächige Abscheidung einer ersten Isolationsschicht (4),

d) Durchführung einer Photolacktechnik (5) zur Definition des Gatebereiches, wobei die Photolackmaske (5) mit Ausnahme des Gatebereiches die über den Source/Drain-Zonen (11) liegende erste leitfähige Schicht (3) und die darüberliegende erste Isolationsschicht (4) abdeckt,

e) Durchführung eines Trockenätzverfahrens zum Struktu rieren der ersten leitfähigen Schicht - (3) und der darüberliegenden ersten Isolationsschicht (4), wobei der Gate-Bereich freigelegt wird,

f) Entfernen der Photolackmaske (5),

g) ganzflächige Abscheidung einer zweiten Isolationsschicht (6) und Durchführung eines ganzflächigen Ätzprozesses, wobei die zweite Isolationsschicht (6) bis auf die lateralen Isolationsstege (7) an den Flanken der Schichtstrukturen (3, 4) der ersten leitfähigen Schicht und der ersten Isolationsschicht entfernt wird,

h) Durchführung einer thermischen Behandlung zur Erzeugung des Gateoxids (8),

i) ganzflächiges Abscheiden einer zweiten leitfähigen Schicht (9) vom zweiten Leitungstyp, wobei die Schichtdicke mindestens die Hälfte der gewünschten Gatelänge beträgt,

j) Aufbringen einer Photolackmaske auf den für den Gate-Elektrodenanschluß vorgesehenen Bereich der zweiten leitfähigen Schicht (9),

k) Entfernung der zweiten leitfähigen Schicht (9) durch Rückätzen bis auf die Höhe der mit den lateralen Isolationsstegen (7) versehenen Schichtstrukturen (3, 4) der ersten leitfähigen Schicht und der ersten Isolationsschicht,

l) Durchführung einer Temperaturbehandlung zur Erzeugung der Source/Drain-Zonen (11) durch Ausdiffusion des Dotierstoffes aus der ersten leitfähigen Schicht (3),

m) Erzeugung einer als Isolationsoxid dienenden Zwischenschicht, Öffnen der Kontaktlöcher zu den Source/Drain-und gate-Anschlüssen und Durchführung der Metallisierung in bekannter Weise.

7. Verfahren nach Anspruch 6, **dadurch gekennzeichnet**, daß zwischen den Verfahrensschritten a) und b) eine doppelte Ionenimplantation von Dotierstoffen eines ersten Leitungstyps durchgeführt wird.

8. Verfahren nach Anspruch 6 und 7, **dadurch gekennzeichnet**, daß die Dotierung der ersten und zweiten leitfähigen Schicht (3, 9), welche vorzugsweise aus Polysilizium, Metallsilizid oder aus einer Doppelschicht von Polysilizium und Metallsilizid besteht, nach ihrer Abscheidung durch Ionenimplantation erfolgt.

9. Verfahren nach einem der Ansprüche 6 bis 8, **dadurch gekennzeichnet**, daß bei der Herstellung von n-Kanal-MOS-Transistoren als Dotierstoffe für die erste leitfähige Schicht (3) Phosphor und/oder Arsen verwendet werden.

10. Verfahren nach einem der Ansprüche 6 bis 9, **dadurch gekennzeichnet** daß die Trennung der aktiven Transistorbereiche nach Verfahrensschritt a) nicht durch das LOCOS-Verfahren, sondern durch Einätzen von Gräben in das Substrat und Auffüllen mit Isolationsmaterial (trench isolation) durchgeführt wird.

11. Verfahren nach einem der Ansprüche 6 bis 10, **dadurch gekennzeichnet**, daß die Trockenätzprozesse bei Verfahrensschritt e) durch reaktives Ionenätzen in einer Gasatmosphäre aus Trifluormethan und Sauerstoff und nachfolgendes Plasmaätzen in einer Gasatmosphäre aus Tetrachlorkohlenstoff und Helium durchgeführt werden und bei Verfahrensschritt g) durch reaktives Ionenätzen in einer Gasatmosphäre aus Trifluormethan und Sauerstoff erfolgt.

FIG 1

FIG 2

FIG 3

FIG 4

FIG 5

FIG 6

FIG7

FIG 8

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0 083 785 (INTERNATIONAL BUSINESS MACHINES CORP.) * Ansprüche 1-12; Figur 6 * | 1,2 | H 01 L 29/78 H 01 L 21/28 H 01 L 27/08 |
| A | * Seite 1, Zeilen 1-5; Seite 5, Zeile 18 - Seite 6, Zeile 5; Seite 7, Zeile 28 - Seite 8, Zeile 7; Ansprüche 1-12 * | 4,6,10 ,11 | |
| | --- | | |
| A | EP-A-0 052 989 (WESTERN ELECTRIC CO., INC.) * Zusammenfassung; Ansprüche 1-6 * | 1-3 | |
| | --- | | |
| A | IEEE TRANSACTIONS ON ELECTRON DEVICES, Band ED-32, Nr. 2, Februar 1985, Seiten 184-193, IEEE, New York, US; T. YAMAGUCHI et al.: "Process and device performance of submicrometer-channel CMOS devices using deep-trench isolation and self-aligned TiSi2 technologies" * Seiten 184-186, Abschnitt: "Device structure and process"; Figur 1 * | 1,10 | RECHERCHIERTE SACHGEBIETE (Int. Cl.4) H 01 L |
| | --- -/- | | |

Der vorliegende Recherchenbericht wurde für alle Patentansprüche erstellt.

| Recherchenort DEN HAAG | Abschlußdatum der Recherche 18-03-1987 | Prüfer ZOLLFRANK G.O. |
|---|---|---|

Europäisches
Patentamt

**EUROPÄISCHER RECHERCHENBERICHT**

Nummer der Anmeldung

EP 86 11 6740

Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | IBM TECHNICAL DISCLOSURE BULLETIN, Band 23, Nr. 11, April 1981, Seiten 5190-5193, New York, US; T.H. NING: "Silicon-gate MOSFET with self-aligned buried source and drain contacts" * Insgesamt * | 1 | |
| | ----- | | |
| | | | RECHERCHIERTE SACHGEBIETE (Int. Cl.4) |

Der vorliegende Recherchenbericht wurde für alle Patentansprüche erstellt.

| Recherchenort | Abschlußdatum der Recherche | Prüfer |
|---|---|---|
| DEN HAAG | 18-03-1987 | ZOLLFRANK G.O. |